# EUROPEAN PATENT SPECIFICATION

(11) **EP 0 657 928 B1**
(45) Date of publication and mention of the grant of the patent: **27.02.2002**
(21) Application number: 94309254.4
(22) Date of filing: 12.12.1994
(51) Int. Cl.: H01L 21/82, H01L 27/115

(54) **Non-volatile memory devices**
Nichtflüchtige Speicheranordnung
Dispositif de mémoire non-volatile

(30) Priority: 10.12.1993 US 165401
(43) Date of publication of application: 14.06.1995
(73) Proprietor: ADVANCED MICRO DEVICES INC., Sunnyvale, California 94088-3453 (US)
(72) Inventor: Richart, Robert B., Austin, Texas 78739 (US); Garg, Shyam G., Austin, Texas 78739 (US); Moore, Bradley T.,Jr., Austin, Texas 78746 (US)
(74) Representative: Brookes Batchellor

(56) References cited:
- EP-A- 0 461 764
- EP-A- 0 464 432
- EP-A- 0 552 531
- EP-A- 0 573 169
- US-A- 5 120 671
- US-A- 5 151 375

## Description

This invention relates to integrated circuits and more particularly to a virtual ground non-volatile memory array with self-aligned interpoly dielectrics and method for manufacturing same.

There are many types of non-volatile memory, often called read only memory (ROM) or programmable read only memory (PROM). Non-volatile memory can be formed in either bipolar or MOS technology. Most MOS PROMs can be formed using one of three currently available technologies (EPROM, EEPROM or FLASH EPROM).

Non-volatile MOS PROMs are designed and perform in numerous similar ways, and can be achieved using many well-known technologies such as: (i) floating gate tunnel oxide, (ii) textured poly, (iii) metal nitride oxide silicon (MNOS), and (iv) EPROM - tunnel oxide (ETOX). Program and erase of the corresponding EPROM cell differs depending upon which technology is used. For example, a floating gate tunnel oxide EPROM transistor is programmed (moving electrons into the floating gate) by biasing the control gate, while erasure (moving electrons out of the floating gate) is achieved by biasing the drain. Programming a textured poly-type EPROM device is achieved by electrons tunneling from a first polysilicon to a second polysilicon, wherein erase is achieved by electrons tunneling from the second polysilicon to a third polysilicon. MNOS-type devices allow charge to be stored in discrete traps in the bulk of the nitride. In each form of EPROM, it is generally recognized that stacked polysilicon conductors be used to perform the program and erase function. A comparison on floating gate tunnel oxide, textured poly, MNOS technologies and the program and erase thereof is described by S. Lai et al., "Comparison and Trends in Today's Dominate E² Technologies", *Int'l Electron Devices Meeting Tech. Digest,* (1986) pp. 580-583 (herein incorporated by reference).

In order to form the stacked polysilicon conductors (one being a floating gate conductor and the other being a control gate conductor) numerous processing steps are required. Placement of the tunneling oxide, the floating gate and the dielectric between the floating gate and the control gate must be carefully performed such that each structure is aligned during the lithography steps. It is also essential that the floating gate, control gate, tunnel oxide and interpoly dielectric be of small critical dimensions and placed close to one another in order to provide a dense array of programmable transistors coupled to corresponding word and bit lines extending throughout the array. In an effort to minimize mis-alignment and bird-beak encroachment problems often associated with field oxide mis-alignment relative to overlying polysilicon, recent work has been performed to self-align the source region with the field oxide region as taught in U.S. Patent No. 5,120,671 to Tang et al. (herein incorporated by reference). Self-aligning the source with the field oxide also allows the added advantage of making the source region contiguous in order to couple an entire row or column of adjacent transistors to a physically grounded power supply.

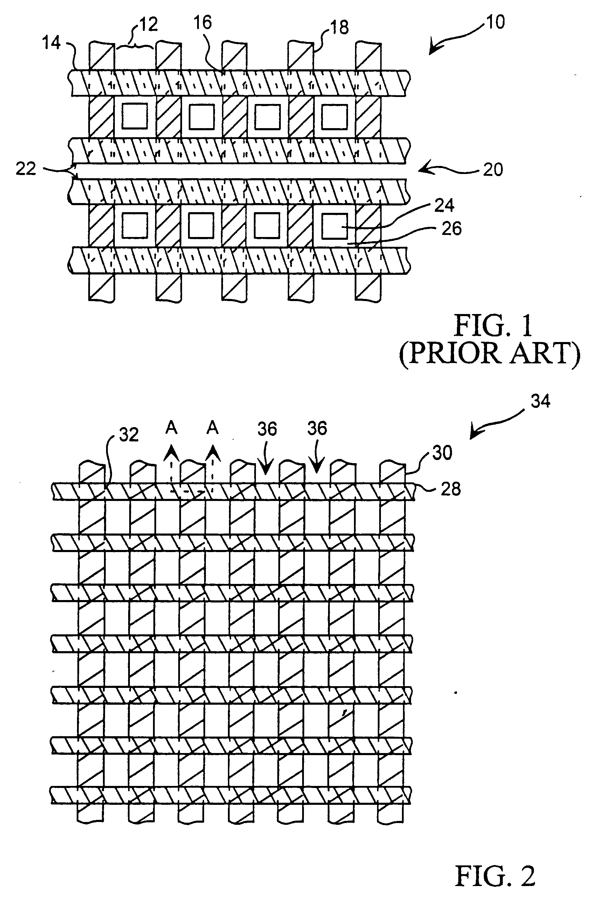

An EPROM array with a contiguous, self-aligned source region is shown in Fig. 1. Array 10 includes a plurality of programmable transistors, each transistor having a channel region 12 placed below a stacked pair of control and floating gates 14 and 16. Control gate 14 is an elongated polysilicon strip placed a spaced distance (spaced by a dielectric) over floating gate 16. Field oxide 18 dielectrically isolates transistors from one another, and are etched or removed within the source regions 20 at edge 22 of polysilicon 14 by the well-known self-aligning process described above. Metalization layers (not shown) can be placed into contact windows 24 for making contact to drain regions 26, in order to form bit line conductors of the array.

The EPROM array shown in Fig. 1 requires numerous contacts 24 be placed within the array. Geometry necessary to accommodate contacts forces an array area which can be quite large for multimegabit memories. In an effort to reduce array size for large memories, a higher density configuration has recently been advanced, as shown in Fig. 2. The array of Fig. 2 does not require contacts be placed within the array. If a transistor is selected, one side of the transistor channel is designated by the decode circuitry as either a ground or a bit line. As such, the contactless array of Fig. 2 is often referred to as "virtual ground" array.

Virtual ground arrays generally utilize control polysilicon strips 28 be placed perpendicular to and a spaced distance over floating polysilicon strips 30. Control polysilicon 28 is coupled to a word line, and bit lines are formed between laterally spaced floating polysilicon 30 (i.e., within the drain area, on one side of channel 32). Channel 32, often called a gate region, is formed within the substrate beneath floating polysilicon 30. Channel 32 is controlled by the overlying polysilicon 28. Source (or drain) regions are formed on opposite sides of channel 32 or floating polysilicon 30. If one side of floating gate 30 is designed as the drain, the other side can be designated as a grounded source. The drain extends as a contiguous diffusion region beneath a field oxide and between pairs of adjacent floating gates. The entire contiguous diffusion area or drain can then be accessed via a contact placed near the periphery of the array 34.

Although a virtual ground array 34 provides a more dense configuration than a common source array 10, virtual ground arrays require bit line diffusion areas 36 (drain or source areas) be buried within the substrate and beneath a bit line oxide, as will be described below. Formation of buried bit line diffusions, overlying bit line oxides and interpoly dielectrics, all require careful attention be paid to the lithography process. Any mis-alignment or mis-processing could have serious consequences in the operation of the array. A single inoperable transistor could cause an ensuing part to fail. Thus, it is important that when processing a virtual ground array careful attention must be paid to each processing step.

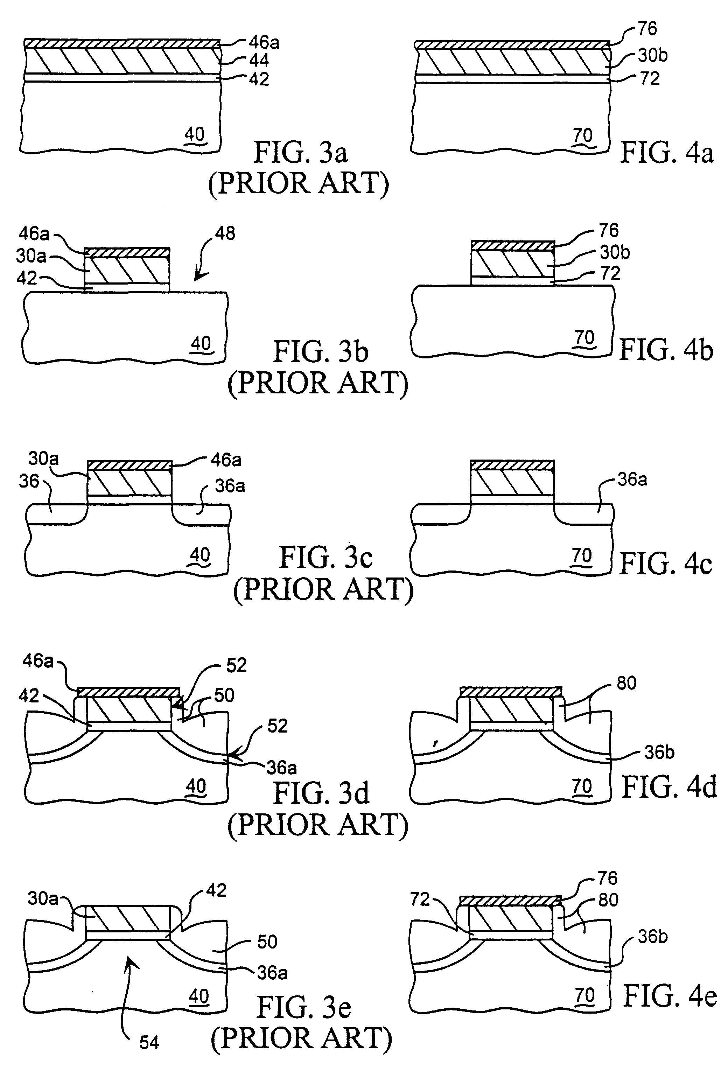

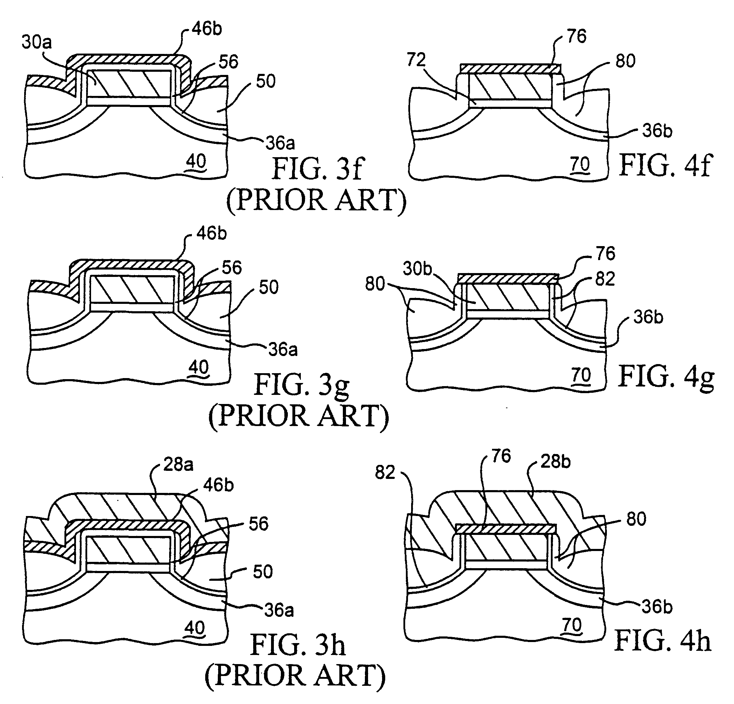

Referring now to Figs. 3a-3h, cross-sectional views taken during various processing steps of a single programmable transistor along plane A-A of Fig. 2 are shown. Placed on the upper surface of a silicon substrate 40 is a first gate oxide 42. Gate oxide 42, often referred to as "tunnel oxide" allows electron transfer from the source or drain region to an overlying floating polysilicon 30a. A description of electron transfer through tunnel oxide, based upon well-known EPROM-tunnel oxide (ETOX) technology is provided by K. Robinson, "Endurance Brightens the Future of Flash -- Memory as a Viable Mask-Storage Alternative," *Electronic Design News,* (November 1988) pp. 167-169 (herein incorporated by reference).

Placed on the upper surface of floating polysilicon 30a, is an interpoly dielectric 46a. Dielectric 46a is preferably a trilayer structure comprising oxide-nitride-oxide layering. The bottom layer of the trilayer structure is a thermally grown oxide (thermally grown from polysilicon 30a feed stock) similar to thermally grown oxide 42. The bottom layer of the trilayer structure is approximately 120 angstroms (Å) in thickness. A nitride is then deposited over the bottom oxide layer using conventional chemical vapor deposition (CVD) techniques to, e.g., a thickness of approximately 190 Å, and the overlying oxide grown upon the nitride is, e.g., generally 40 Å in thickness. Using a trilayer dielectric is advantageous in that (i) it provides good data retention characteristics, (ii) it is fairly thin in order to achieve good coupling between control and floating polysilicon, and (iii) the nitride prevents oxide thickening in subsequent oxidation steps. The nitride layer can be formed in a low pressure CVD chamber, whereas the bottom oxide of the trilayer structure (polysilicon oxide) is grown by a low-temperature dry oxidation process. The upper oxide (nitride oxide) can be formed by high-temperature wet oxidation. A general description of oxide-nitride-oxide (ONO) interpoly dielectrics within virtual ground PROM architectures is described by Y. Hisamune, et al., "A 3.6 µm² Memory Structure For 16MB EPROMS," *IEDM*, (1989) pp. 583-586 (herein incorporated by reference); B. Woo, et al., "A Novel Memory Cell Using Flash Array Contactless EPROM (FACE) Technology," *IEDM*, (1990) pp. 91-94 (herein incorporated by reference).

After first gate oxide 42, floating polysilicon 30a and interpoly dielectric 46a have been placed across substrate 40 within the core area, photoresist is deposited across the top of the substrate topography and select regions of the photoresist are exposed to radiation. Depending upon whether the photoresist is positive or negative, various areas of the photoresist will be polymerized in accordance with the mask pattern placed proximate to the photoresist. The polymerized photoresist is retained while the unpolymerized photoresist is removed thereby providing etched windows to the underlying substrate topography. As shown in Fig. 3b, select regions of oxide 42, polysilicon 30a, and dielectric 46a are removed in accordance with the patterned photoresist. Etched areas 48 are thereafter adapted to receive implant of impurities necessary to form bit line diffusion areas 36a shown in Fig. 3c. Using, as an example, a P-type substrate or well 40, bit line areas 36a are doped using arsenic ions. The arsenic ions implant within the opposite polarity substrate 40 to form conductive regions therein, according to well-known source/drain implant techniques.

Soon after bit line diffusions 36a are placed, a bit line oxide 50 is thermally grown at the silicon-oxide interface 52, as shown in Fig. 3d. It is well-known that oxide grows on many feed stock substances such as silicon and polycrystalline silicon (polysilicon). Oxide 50 grows at a faster rate upon the silicon substrate 40 than upon the side wall of polysilicon 30a, as evidenced by the illustration of Fig. 3d. It is also recognized that oxide 50 can be grown in a dry oxygen ambient since dry oxide is less porous than wet oxide. As such, dry oxide generally grows at a slower rate than wet oxide, provided all other conditions are equal. However, the dry oxide exhibits a lesser tendency to allow carriers to pass through the less porous substance. Accordingly, dry oxide achieves better data retention by minimizing inadvertent Fowler-Nordheim emissions.

An important aspect of dielectric 46a is the ability of Si₃N₄ to minimize growth of oxide upon the dielectric. Nitride is a well-known substance which does not accept a substantial amount of oxide growth thereon. Accordingly, oxide growth is limited to the bit line areas 36a and the sides of the polycrystalline silicon 30a. Minimum growth at the upper surface of polysilicon 30a ensures a thin dielectric 46a and, as a result, provides strong coupling between polysilicon 30a and any overlying conductor placed upon the dielectric.

An inherent problem with thermally grown oxide 50 is the need for raising the temperature of the substrate during the growth process. Generally speaking, dry oxidation occurs at a slower rate than wet oxidation. In order to enhance the dry oxidation process, the temperature of the substrate is oftentimes raised to a level between 800°C to 1100° C. Thermally cycling the substrate 40 causes bit line areas 36a to diffuse into and laterally along substrate 40. As shown in Fig. 3e, bit line areas 36a can extend into channel region 54 causing what is commonly known as "short channel effects". Short channel effects caused by shrinking effective gate lengths, leads to a reduction in threshold voltages of the associated device. Short channel effects can also cause subthreshold current through the channel (i.e., punchthrough current within the substrate bulk or drain-induced barrier lower (DIBL) current at or near the substrate surface. Punchthrough and DIBL-induced current occurs between the closely spaced bit line areas when subthreshold voltages are applied to the gate, and normal voltage levels exist between the drain and source. Punchthrough and DIBL-induced current can lead to break-down voltage (BVDSS) problems, which is well documented and is particularly acute in short channel length transistors.

Referring to Fig. 3e, dielectric 46a is removed according to conventional techniques for removing oxide and silicon nitride. Typically, oxide (silicon dioxide) can be removed by wet etching or plasma etching. Plasma etching includes reactive ion etching and its derivatives, whereby wet etching includes hydrogen fluoride (HF) in various dilutions in water. Silicon nitride can also be wet etched with either HF solutions or with hot phosphoric acid. The etching process is sufficiently selective in order to remove predominant amounts of dielectric 46a while retaining bit line oxide 50.

It is appreciated from the drawings of Figs. 3d and 3e, that dielectric 46a is only temporarily placed. Dielectric 46a is needed only to prevent oxygen diffusion to the upper surface of polysilicon 30a during times in which bit line oxide 50 is grown. Thereafter, dielectric 46a is removed in order to provide a more planer upper polysilicon surface for receiving a second interpoly dielectric 46b. Removing dielectric 46a and replacing it with another interpoly dielectric 46b, which extends around a substantial portion of three sides of floating polysilicon 30a, occurs in such a manner that dielectric 46a is often referred to as a "sacrificial dielectric". The problems inherent in removing sacrificial dielectrics are manyfold. First, the etching process necessary to remove a trilayer structure of oxide-nitride-oxide is fairly complex. Oftentimes, small areas of silicon nitride or silicon dioxide are left after they should have been removed. The residue associated with the wet or dry etching process can lead to non-planer upper surfaces. Secondly, removal of the trilayer structure may not be complete across the entire surface leading to a thicker than expected subsequent dielectric, which can lead to problems of lower than expected electrical coupling to the overlying control polysilicon. Thirdly, poor selectivity during the etching process can inadvertently remove bit line oxide 50 causing higher than expected electrical coupling between bit line areas 36a and overlying control polysilicon. It is therefore, important to try and minimize the number of processing steps and particularly to minimize or eliminate under and over etching of the sacrificial dielectric and areas surrounding the same.

After the sacrificial dielectric 46a is removed, another interpoly dielectric 46b is placed across the upper surface of floating polysilicon 30a and bit line oxides 50. Reintroduction of an ONO trilayer involves thermally growing corresponding oxides. In particular, a polysilicon/silicon oxide 56 (grown from, and part of, ONO 46b) is formed as a thin layer. During growth, substrate 40 is exposed to additional thermal cycles causing bit line areas 36a to further diffuse laterally and to a deeper depth within substrate 40. Lateral diffusion adds to the short channel effects described above, and deeper diffusions produce carrier mobility across channel regions thereby producing higher junction capacitance and a slower device. Still further, thermal cycles associated with substrate 40 cause mobile carriers within channel 54 to diffuse to a deeper depth thereby offsetting the advantages of shallow channel devices.

Fig. 3g illustrates an oxide 56 grown at the interface region between the silicon (or polysilicon) and oxide 50. Oxide 56 is the polysilicon oxide normally associated with the ONO trilayer, and is incorporated prior to the introduction of second polysilicon 28a. A second gate oxide which must be grown for the peripheral transistors affects the core thermally, but has no effect on core oxides due to the blocking nitride of the ONO trilayer. Second polysilicon (or poly) 28 is placed in both the core (array) area as well as in periphery areas surrounding the array. Second poly 28 forms the gate conductors within the core regions of the EPROM as well as any logic necessary for operating the control/decode circuitry. Second poly 28 associated with the array area is often referred to as control polysilicon. Fig. 3h illustrates control (or second) polysilicon 28 placed on the upper surface of interpoly dielectric 46b to complete a stacked gate region illustrating cross-section along plane A-A of Fig. 2. It is well known that further processing is required to self-align etch the floating gates to the control gates. It is also well recognized that additional metalization layers can be formed in contact regions and upon a monolithic circuit embodying a virtual ground array 20 of conventional design. As such, metalization in contact regions is formed subsequent to the step shown in Fig. 3h in accordance with technology well-known to the skilled artisan.

EP-A-0,552,531 discloses a FLASH EPROM memory array in which a single source diffusion is shared by two columns of transistors and the source diffusion regions are self-aligned to the floating gates of the transistors in the adjacent columns. When implanting the source regions, a source oxide is grown over the source region, and oxides are grown along the sides of the floating gates to isolate the gates from the subsequently formed polysilicon wordlines.

EP-A-0,464,432 discloses an array of EEPROM cells in which each cell has a floating gate formed from a first polysilicon layer and a control gate formed from a second polysilicon layer. Parallel bit lines form the drain and source regions of parallel columns of MOS transistors.

EP-A-0,461,764 discloses an EPROM virtual ground array in which the floating gates of the floating gate transistors are formed from a first polysilicon layer and a wet oxidation process is used when forming the final oxide layer of an ONO dielectric that is sandwiched between the first polysilicon layer and a second polysilicon layer.

EP-A-0,573,169 discloses the use of plasma etching to form parallel strips of ONO/poly 1 in a process for forming a flash EPROM array.

The problems outlined above are in large part solved by the virtual ground non-volatile memory to be described herein.

The present invention according to claims 1 and 11 a method for manufacturing a non-volatile memory comprising the steps of growing a first gate oxide upon a silicon substrate, and depositing a floating polysilicon upon the first gate oxide; depositing a dielectric upon the floating polysilicon; removing the floating polysilicon, the dielectric, and the first gate oxide to form a plurality of floating polysilicon strips spaced apart from one another and a plurality of bit line areas residing laterally adjacent to the plurality of floating polysilicon strips; implanting impurities into the bit line areas; growing a bit line oxide within the bit line areas and above the implanted impurities while thereafter retaining the dielectric upon the upper surface of the floating polysilicon; and growing a second gate oxide within the bit line areas and on the side of the floating polysilicon, characterised in that a first portion of the second gate oxide is interposed between the sidewall surfaces of the floating polysilicon strip and the bit line oxide, and a second portion of the second gate oxide is interposed between the silicon substrate and the bit line oxide.

Preferably the bit line oxide is wet grown and the second gate oxide is then dry grown through the wet grown oxide. Because the wet oxidation process can be carried out at a lower temperature than the dry oxidation process, this prevents the "short channel effects" previously discussed with reference to Fig.3e. Moreover the dry oxide fills porous gaps in the wet oxide, decreasing electron mobility and enhancing data retention of programmed voltages.

A virtual ground memory embodying the invention comprises a self-aligned interpoly dielectric which is purposefully not a sacrificial interpoly dielectric. By avoiding sacrificial dielectrics, the present memory array avoids subjecting the surface topography to inaccurate etching processes, and also avoids subjecting the silicon substrate and bit line diffusions to undue thermal cycles. Accordingly, a more closely controlled dielectric thickness can be achieved between floating and control polysilicon. Further, bit line oxides do not experience sacrificial etches of prior designs. By avoiding sacrificial dielectrics and the added steps associated therewith, the self-aligned dielectrics and. memory circuits incorporating those dielectrics achieve higher performance and more consistent performance for each programmable transistor within the array.

Broadly speaking, we shall describe a non-volatile memory array comprising a semiconductor substrate and a first gate oxide placed upon the substrate. A plurality of floating polysilicon strips are spaced apart from each other and placed upon the first gate oxide to form a programmable region. A plurality of control polysilicon strips are spaced apart from each other and extend perpendicular to each of the floating polysilicon strips. A dielectric is patterned only in the cross-over regions directly between the floating polysilicon strips and the control polysilicon strips. The dielectric is aligned with the edges of the respective floating polysilicon strips and respective control polysilicon strips. A plurality of coplanar bit line oxides are formed beneath the control polysilicon strips and between the floating polysilicon strips. Furthermore, a plurality of diffusion regions are formed beneath respective bit line oxides. A set of the plurality of the diffusion regions form a conductive channel extending perpendicular to and between adjacent control polysilicon strips.

The interpoly dielectric comprises polysilicon oxide, nitride, and nitride oxide placed in a trilayer structure. The edges of the floating polysilicon strips comprise wet oxide grown thereon followed by dry oxide grown at the wet oxide-polysilicon interface. The wet oxide is formed in a steam ambient and the dry oxide is formed in an O₂ ambient. A plurality of diffusion regions forming a conductive channel extends across the memory array to a contact point adapted for receiving a ground voltage.

We shall further describe a method for manufacturing a non-volatile memory. The method comprises the steps of growing a first gate oxide upon a silicon substrate, and then depositing a floating polysilicon upon the first gate oxide. Next, a dielectric is deposited upon the floating polysilicon, wherein portions of the floating polysilicon and dielectric are removed from a plurality of bit line areas spaced across the substrate. The bit line areas are then implanted with impurities, wherein the impurities reside at a specified depth within the substrate. A bit line oxide is then grown within the bit line areas at the oxide-silicon interface and above the implanted impurities. The dielectric is retained upon the upper surface of the floating polysilicon after the bit line oxide is grown, and thereafter, a second gate oxide is grown within the bit line areas.

The step of removing floating polysilicon and dielectric from the bit line areas comprises the steps of placing photoresist upon the dielectric and polymerizing the photoresist in gate regions overlying channel areas within the substrate. Next, unpolymerized photoresist is removed to form windows above respective bit line areas such that portions of the dielectric and underlying floating polysilicon can be etched away.

The step of growing the bit line oxide comprises pressurizing and heating a furnace to approximately 1-2 atmospheres and 900-950° C, respectively, and then placing the substrate into the furnace and passing steam across the substrate at a rate of approximately 1-8 slpm. The step of growing the second gate oxide comprises pressurizing and heating a furnace to approximately 1-2 atmospheres and 1000° C, respectively, and then placing the substrate into the furnace and passing O₂ across the substrate at a rate of approximately 10 slpm.

Other objects and advantages of the invention will become apparent upon reading the following detailed description and upon reference to the accompanying drawings in which, by way of example only:
Fig. 1 is a top view of a common ground non-volatile memory array according to a prior art design;
Fig. 2 is a top view of a virtual ground non-volatile memory array;
Fig. 3a-3h are cross-sectional views of various processing steps shown along plane A-A of Fig. 2, wherein the resulting product is formed according to a prior art design; and
Fig. 4a-4h are cross-sectional views of various processing steps shown along plane A-A of Fig. 2, wherein the resulting product is formed according to the present invention.

While the invention is susceptible to various modifications and alternative forms, specific embodiments thereof are shown by detail.

Turning now to Figs. 4a-4h cross-sectional views of various processes and steps of this example of the invention are shown along plane A-A of Fig. 2. Well-known processing steps and device configurations not described in detail in the steps illustrated in Figs. 4a-4h, are purposely not shown in order not to unnecessarily obscure the present invention.

The steps shown in Figs. 4a-4h describe a processing methodology for allowing an interpoly dielectric to be self-aligned with the edges of a floating polysilicon strip residing below the dielectric. This method and device formed therefrom eliminate the need for sacrificial dielectrics and the etching and thermal cycles associated therewith. The memory array is particularly suitable for use with non-volatile memory cells such as PROMs (i.e., EPROMs, FLASH EPROMs, and EEPROMs).

Turning now to the drawings, Figs. 4a-4c illustrate first gate oxide 72, floating polysilicon 30b and ONO interpoly dielectric 76 placed on the upper surface of substrate 70. Oxide 72, polysilicon 30b and dielectric 76 can be selectively removed in order to allow implantation of bit line areas 78.

Once bit line areas 78 are formed, thermal oxidation occurs at the silicon-oxide and polysilicon-oxide interfaces. A bit line oxide 80 results from the oxidation step. Preferably, oxidation of bit line areas 78 to form bit line oxides 80 occur within a steam ambient. Bit line oxide 80 is therefore a wet oxide having the advantages of a higher oxidation rate at a lower oxidation temperature. Wet bit line oxide is formed by pressurizing the oxide furnace to approximately 1-2 atmospheres and at a temperature of approximately 900-950° C. Steam is passed across the substrate at a rate of approximately 1-8 slpm. By using steam at the above-defined parameters, a wet oxide thickness at the substrate surface of approximately 1300 Å can be formed in approximately 20-40 minutes. It is important that the oxide be formed not only quickly but at minimal elevated temperature. Typically, at the same growth rate set forth above, dry oxides require a temperature 100° C higher than wet oxides. The temperature differential leads to additional drive in of the bit line area 78 and enhances problems of short channel effects.

As shown in Fig. 4e, the patterned interpoly dielectric 76 is not removed and remains throughout the processing steps. As such, dielectric 76 is not a sacrificial dielectric as in conventional designs, and therefore, does not require additional etching steps be taken which could cause under etch or over etch of substrate topography. Wet etch or plasma etch techniques are not needed, and the problems which might be associated with those techniques are avoided.

Fig. 4f illustrates floating polysilicon 74 surrounded by wet bit line oxide 80 and ONO dielectric 76 in order to achieve good data retention of a "programmed" voltage upon floating polysilicon 30b. Once programmed, polysilicon 30b retains the programmed voltage resulting from electron transfer from the programmable drain area bit line through first oxide 72 (tunnel oxide). The charge remains within floating polysilicon 30b for a long period of time due in part to the larger thickness achieved by wet oxide at the side walls and the ONO at the top of polysilicon 30b. However, wet oxide by itself cannot retain the charge long enough to be commercially viable in the application herein specified.

Interpoly dielectric 76 is relatively thin, comprising a bottom layer polysilicon oxide of approximately 120 Å, a nitride of approximately 190 Å and an overlying nitride-oxide of approximately 40 Å. The thin trilayer structure provides good coupling between floating polysilicon 30b and an overlying conductor, such as a control conductor described below. The nitride within the ONO structure prevents additional oxide growth at the upper surface of floating polysilicon 30b and between the stacked polysilicon members. Additional oxide generally occurs during a time in which a second gate oxide 82 is formed to achieve periphery transistors (transistors outside of the non-volatile array). Second gate oxide 82 is a dry oxide, wherein oxide 82 is formed by placing substrate 70 into a furnace pressurized at approximately 1-2 atmospheres and heated to approximately 1000° C. Dry oxygen or O₂ is passed across the substrate at a rate of approximately 10 slpm. Dry oxide is well-known to be less porous than wet oxide. The dry oxide forms at a slower rate than wet oxide, unless it is subjected to a higher temperature. The temperature and parameters defined above allow dry oxide of approximately 200-300 Å in thickness to grow at the interface region between polysilicon 30b/substrate 70 and bit line oxide 80. Dry oxide 82 enhances the integrity of the thicker wet oxide 80 by filling porous gaps within the wet oxide at the interface region. In doing so, dry oxide formation decreases electron mobility within the resulting oxide structure and thereby further enhances data retention of programmed voltage upon polysilicon 30b. It is important to note that wet oxidation by itself yields poor data retention. Dry oxide of 120 Å grown from the polysilicon improves data retention, but it is still substandard. Dry oxide of 200-300 Å grown from polysilicon 30b fills all gaps in the wet oxide, thereby solving the data retention problem. Note that both the prior art process and the present process subject the device to this thermal cycle, which is necessary to form the gate oxide for peripheral transistors. However, the prior art process can receive no oxidizing benefit due to its blocking, wrap-around ONO trilayer.

After dry oxide 82 is grown, a second polysilicon layer is formed at select regions across the entire monolithic circuit, in both the array and periphery areas. The polysilicon within the array is often defined as the control polysilicon, as shown by reference numeral 28b of Fig. 4h. Control polysilicon 28b is well-known in design and function as being the conductive polysilicon which forms word lines within the array and enables programmability (reading from and writing to) of select transistors within the array.

It is well-known and generally recognized that there are numerous steps prior to and after the steps shown in Figs. 4a-4h. To complete a non-volatile memory device, such as, for example, an ETOX double poly FLASH EPROM device, it is necessary to connect control and floating polysilicon as well as each bit line diffusion to respective conductors and/or decode circuitry arranged near the periphery of the EPROM array. This may require deposition of contact windows and additional metalization layers as well as passivation to the upper topography according to well-known MOS processing techniques. In order not to unnecessarily obscure the present invention, well-known processing steps which proceed or are subsequent to those taught in Figs. 4a-4h are not described in detail, however, it will be obvious to one skilled in the art that such specific steps would be employed to provide a non-volatile memory device. Furthermore, it would be obvious to a person skilled in the art to include many intermediate steps which are not shown for sake of brevity.

It will be appreciated by those skilled in the art having the benefit of this disclosure that this invention is believed to be capable of application with numerous types of non-volatile memory devices including, but not limited to EPROM, FLASH EPROM, and/or EEPROM devices. Furthermore, it is also to be understood that the form of the invention shown and described is to be taken as a presently preferred embodiment.

## Claims

1. A method for manufacturing a non-volatile memory comprising the steps of:
growing a first gate oxide (72) upon a silicon substrate (70), and depositing a floating polysilicon (30b) upon said first gate oxide;
depositing a dielectric (76) upon said floating polysilicon;
removing at least a portion of said floating polysilicon, said dielectric, and said first gate oxide to form a plurality of floating polysilicon strips (30) spaced apart from one another and a plurality of bit line areas (36) residing laterally adjacent to the plurality of floating polysilicon strips;
implanting impurities (36a) into said bit line areas;
growing a bit line oxide (80) within said bit line areas and above said implanted impurities while thereafter retaining said dielectric upon the upper surface of said floating polysilicon; and
growing a second gate oxide (82) within said bit line areas and on the side of said floating polysilicon, ***characterised in that*** a first portion of the second gate oxide is interposed between the sidewall surfaces of the floating polysilicon strip and the bit line oxide, and a second portion of the second gate oxide is interposed between the silicon substrate and the bit line oxide.

2. A method according to claim 1, wherein said depositing comprises growing a polysilicon oxide upon said floating polysilicon, thereafter depositing a nitride upon said polysilicon oxide, and thereafter growing a nitride oxide upon said nitride to form a tri-layer oxide-nitride-oxide interpoly dielectric.

3. A method according to claim 2, wherein said interpoly dielectric is configured between said floating polysilicon and a control polysilicon placed thereon.

4. A method according to claim 1, wherein said removing step comprises:
placing photoresist upon said dielectric;
polymerizing said photoresist in gate regions overlying channel areas within said substrate;
removing unpolymerized photoresist to form windows above respective said bit line areas; and
etching said dielectric and underlying floating polysilicon.

5. A method according to claim 4, wherein said etching step comprises plasma etching.

6. A method according to claim 1, wherein the growing of said bit line oxide comprises:
pressurizing and heating a furnace to approximately 1-2 atmospheres and 900-950° C, respectively;
placing said substrate into said furnace; and
passing steam across said substrate at a rate of approximately 1-8 slpm.

7. A method according to claim 1, wherein said growing of said second gate oxide comprises:
pressurizing and heating a furnace to approximately 1-2 atmospheres and 1000° C, respectively;
placing said substrate into said furnace; and
passing O₂ across said substrate at a rate of approximately 10 slpm.

8. A method according to claim 1, wherein said implanting impurities into said bit line areas comprises forming respective source/drain regions, such that select source/drain regions are adapted to selectively couple to a ground voltage.

9. A method according to any one of the preceding claims wherein the bit line oxide (80) is wet grown within the bit line areas (36), and the second gate oxide (82) is dry grown within the bit line areas.

10. A method according to claim 9 wherein the bit line oxide (80) is wet grown within the bit line areas (36) and along the sides of the floating polysilicon (30b), and the second gate oxide (82) is dry grown through the wet grown oxide (80).

11. A non-volatile memory array (34) comprising:
a semiconductor substrate (70) and a first gate oxide (72) placed upon said substrate;
a plurality of floating polysilicon strips (30) spaced apart from each other and placed upon said first gate oxide;
a plurality of control polysilicon strips (28) spaced apart from each other, wherein each of said control polysilicon strips extends perpendicular to each of said floating polysilicon strips;
a dielectric (76) comprising nitride patterned only in crossover regions directly between said floating polysilicon strips and said control polysilicon strips, whereby each said dielectric is aligned with the edges of respective said floating polysilicon strips and respective said control polysilicon strips;
a plurality of coplanar bit line oxides comprising wet oxides (80) formed beneath said control polysilicon strips; and
a plurality of diffusion regions formed beneath respective said bit line oxides, wherein a set of said plurality of said diffusion regions form a conductive channel extending parallel to and between adjacent floating polysilicon strips, **characterized in that** the edges of said floating polysilicon strips comprise said wet oxide (80) grown thereon and a dry oxide (82) grown through said wet oxide.

12. A non-volatile memory array according to claim 11, wherein said dielectric (76) comprises polysilicon oxide, nitride and nitride oxide placed in a trilayer structure.

13. A non-volatile memory array according to claim 11 or claim 12, wherein said wet oxide is formed within a steam ambient and said dry oxide is formed in an O₂ ambient.

14. A non-volatile memory array according to claim 11, wherein said conductive channel extends across the memory array to a contact point adapted for receiving a ground voltage.

## Patentansprüche

1. Verfahren zum Herstellen eines nichtflüchtigen Speichers, mit folgenden Schritten:
Züchten eines ersten Gateoxids (72) auf einem Siliciumsubstrat (70) und Aufbringen eines floatenden Polysiliciums (30b) auf dem ersten Gateoxid;
Aufbringen eines Dielektrikums (76) auf dem floatenden Polysilicium;
Entfernen mindestens eines Teils des floatenden Polysiliciums, des Dielektrikums und des ersten Gateoxids zur Bildung mehrerer voneinander beabstandeter floatender Polysiliciumstreifen (30) und mehrerer Bitleitungsbereiche (36), die seitlich angrenzend an die mehreren floatenden Polysiliciumstreifen angeordnet sind;
Implantieren von Fremdstoffen (36a) in die Bitleitungsbereiche;
Züchten eines Bitleitungsoxids (80) innerhalb der Bitleitungsbereiche und oberhalb der implantierten Fremdstoffe, während das Dielektrikum auf der oberen Fläche des floatenden Polysiliciums verbleibt; und
Züchten eines zweiten Gateoxids (82) innerhalb der Bitleitungsbereiche und auf der Seite des floatenden Polysiliciums,
***dadurch gekennzeichnet, dass***
ein erster Teil des zweiten Gateoxids zwischen den Seitenwandflächen des floatenden Polysiliciumstreifens und dem Bitleitungsoxid angeordnet ist, und ein zweiter Teil des zweiten Gateoxids zwischen dem Siliciumsubstrat und dem Bitleitungsoxid angeordnet ist.

2. Verfahren nach Anspruch 1, bei dem der Schritt des Aufbringens das Züchten eines Polysiliciumoxids auf dem floatenden Polysilicium umfasst, wonach ein Nitrid auf dem Polysiliciumoxid aufgebracht wird und im Anschluss daran zur Bildung eines dreischichtigen Oxid-Nitrid-Oxid-Interpoly-Dielektrikum ein Nitridoxid auf dem Nitrid gezüchtet wird.

3. Verfahren nach Anspruch 2, bei dem das Interpoly-Dielektrikum zwischen dem floatenden Polysilicium und einem darauf befindlichen Steuer-Polysilicium konfiguriert ist.

4. Verfahren nach Anspruch 1, bei dem der Schritt des Entfernens folgendes umfasst:
Platzieren von Fotoresist auf das Dielektrikum;
Polymerisieren des Fotoresists in Gateregionen, die über Kanalbereichen innerhalb des Substrats liegen;
Entfernen von nicht polymerisiertem Fotoresist zur Bildung eines Fensters jeweils oberhalb der Bitleitungsbereiche; und
Ätzen des Dielektrikums und des darunter liegenden floatenden Polysiliciums.

5. Verfahren nach Anspruch 4, bei dem der Schritt des Ätzens Plasmaätzen umfasst.

6. Verfahren nach Anspruch 1, bei dem das Züchten des Bitleitungsoxids folgende Schritte umfasst:
Druckbeaufschlagen und Erwärmen eines Ofens auf ungefähr 1-2 Atmosphären bzw. 900-950 °C;
Einsetzen des Substrats in den Ofen; und
Leiten von Dampf über das Substrat mit einer Rate von ungefähr 1-8 slpm.

7. Verfahren nach Anspruch 1, bei dem das Züchten des zweiten Gateoxids folgende Schritte umfasst:
Druckbeaufschlagung und Erwärmung eines Ofens auf ungefähr 1-2 Atmosphären bzw. 1000 °C;
Einsetzen des Substrats in den Ofen; und
Leiten von O₂ über das Substrat mit einer Rate von ungefähr 10 slpm.

8. Verfahren nach Anspruch 1, bei dem das Implantieren von Fremdstoffen in die Bitleitungsbereiche das Bilden von jeweils Source-/Drain-Regionen umfasst, derart, dass ausgewählte Source-/Drain-Regionen zum selektiven Koppeln mit einer Massespannung vorgesehen sind.

9. Verfahren nach einem der vorhergehenden Ansprüche, bei dem das Bitleitungsoxid (80) innerhalb der Bitleitungsbereiche (36) nass gezüchtet wird und das zweite Gateoxid (82) innerhalb der Bitleitungsbereiche trocken gezüchtet wird.

10. Verfahren nach Anspruch 9, bei dem das Bitleitungsoxid (80) innerhalb der Bitleitungsbereiche (36) und entlang den Seiten des floatenden Polysiliciums (30b) nass gezüchtet wird und das zweite Gateoxid (82) durch das nass gezüchtete Oxid (80) hindurch trocken gezüchtet wird.

11. Nichtflüchtiges Speicherarray (34), mit:
einem Halbleitersubstrat (70) und einem ersten Gateoxid (72) auf dem Substrat;
mehreren voneinander beabstandeten floatenden Polysiliciumstreifen (30) auf dem ersten Gateoxid;
mehreren voneinander beabstandeten Steuer-Poiysiliciumstreifen (28), von denen jeder orthogonal zu den floatenden Polysiliciumstreifen verläuft;
einem Dielektrikum (76), das Nitrid aufweist, welches nur in Überkreuzungsregionen direkt zwischen den floatenden Polysiliciumstreifen und den Steuer-Poiysiiiciumstreifen strukturiert ist, wodurch jedes Dielektrikum zu den Rändern der jeweiligen floatenden Polysiliciumstreifen und der jeweiligen Steuer-Polysiliciumstreifen ausgerichtet ist; wobei die Ränder der floatenden Polysiliciumstreifen nasses Oxid (80) aufweisen, das auf diesen gezüchtet ist, gefolgt von trockenem Oxid (82), das durch das nasse Oxid hindurch gezüchtet ist;
mehreren koplanaren Bitleitungsoxiden (36), die zwischen den Polysiliciumstreifen und den Überkreuzungsregionen sowie unterhalb der Steuer-Polysiliciumstreifen gebildet sind; und
mehreren Diffusionsregionen, die unterhalb der jeweiligen Bitleitungsoxide gebildet sind, wobei eine Gruppe der mehreren Diffusionsregionen einen leitenden Kanal bilden, der parallel zu und zwischen aneinandergrenzenden floatenden Polysiliciumstreifen verläuft.

12. Nichtflüchtiges Speicherarray nach Anspruch 11, bei dem das Dielektrikum (76) in einer dreischichtigen Struktur aufgebrachtes Polysiliciumoxid, Nitrid und Nitridoxid aufweist.

13. Nichtflüchtiges Speicherarray nach Anspruch 11 oder 12, bei dem das Nassoxid in einer Dampfumgebung und das Trockenoxid in einer O₂-Umgebung gebildet wird.

14. Nichtflüchtiges Speicherarray nach Anspruch 11, bei dem der leitende Kanal über das Speicherarray zu einem zum Empfangen einer Massespannung vorgesehenen Kontaktpunkt verläuft.

## Revendications

1. Procédé pour fabriquer une mémoire non volatile comprenant les étapes consistant à :
accroître un premier oxyde de grille (72) sur un substrat en silicone (70), et à déposer un polysilicium flottant (30b) sur ledit premier oxyde de grille ;
déposer un diélectrique (76) sur ledit polysilicium flottant ;
retirer au moins une partie dudit polysilicium flottant, dudit diélectrique, et dudit premier oxyde de grille de manière à former une des pluralité de bandes de polysilicium flottant (30) espacées les unes des autres et une pluralité de zones de lignes binaires (36) disposées de manière latéralement adjacente à la pluralité de bandes de polysilicium flottant ;
implanter des impuretés (36a) dans lesdites zones de lignes binaires ;
accroître un oxyde de ligne binaire (80) à l'intérieur desdites zones de lignes binaires et au-dessus desdites impuretés implantées tout en maintenant ensuite ledit diélectrique sur la surface supérieure dudit polysilicium flottant ; et
accroître un second oxyde de grille (82) à l'intérieur desdites zones de lignes binaires et sur le côté dudit polysilicium flottant, **caractérisé en ce qu'**une première partie du second oxyde de grille est interposée entre les surfaces formant parois latérales de la bande de polysilicium flottant et l'oxyde de ligne binaire, et **en ce qu'**une seconde partie du second oxyde de grille est interposée entre le substrat en silicone et l'oxyde de ligne binaire.

2. Procédé selon la revendication 1, dans lequel ladite étape de dépôt comprend l'étape consistant à accroître un oxyde de polysilicium sur ledit polysilicium flottant, puis à déposer un nitrure sur ledit oxyde de polysilicium, et ensuite à accroître un oxyde de nitrure sur ledit nitrure de manière à former un diélectrique interpoly trois couches oxyde-nitrure-oxyde.

3. Procédé selon la revendication 2, dans lequel ledit diélectrique d'interpole est configuré entre ledit polysilicium flottant et un polysilicium de contrôle placé dessus.

4. Procédé selon la revendication 1, dans lequel ladite étape de retrait comprend :
l'étape consistant à placer un photorésist sur ledit diélectrique ;
l'étape consistant à polymériser ledit photorésist dans des zones de grille recouvrant des zones de canal à l'intérieur dudit substrat ;
l'étape consistant à retirer le photorésist non polymérisé de manière à former des fenêtres au-dessus desdites zones de lignes binaires respectives ; et
l'étape consistant à graver ledit diélectrique et le polysilicim flottant sous-jacent.

5. Procédé selon la revendication 4, dans lequel ladite étape consistant à graver comprend le fait de graver du plasma.

6. Procédé selon la revendication 1, dans lequel l'accroissement dudit oxyde de ligne binaire comprend :
le fait de pressuriser et de chauffer un four à environ 1 à 2 atmosphères et 900 à 950°C, respectivement ;
le fait de placer ledit substrat dans ledit four ; et
le fait de passer de la vapeur à travers ledit substrat à un débit d'environ 1 à 8 slpm.

7. Procédé selon la revendication 1, dans lequel ladite étape d'accroissement dudit second oxyde de grille comprend :
l'étape consistant à pressuriser et à chauffer un four à environ 1 à 2 atmosphères et à 1000°C, respectivement ;
l'étape consistant à placer ledit substrat dans ledit four ; et
l'étape consistant à passer de l'O₂ à travers ledit substrat à un taux d'environ 10 slpm.

8. Procédé selon la revendication 1, dans lequel ladite étape consistant à implanter des impuretés dans lesdites zones de lignes binaires comprend l'étape consistant à former des zones de source/drain respectives, de telle sorte que les zones de source/drain choisies soient adaptées pour être couplées de manière sélective à une tension au sol.

9. Procédé selon l'une quelconque des revendications précédentes, dans lequel l'oxyde de ligne binaire (80) croît en milieu humide à l'intérieur des zones de lignes binaires (36), et le second oxyde de grille (82) croît en milieu sec à l'intérieur des zones de lignes binaires.

10. Procédé selon la revendication 9, dans lequel l'oxyde de ligne binaire (80) croît en milieu humide à l'intérieur des zones de lignes binaires (36) et le long des côtés du polysilicium flottant (30b), et le second oxyde de grille (82) croît en milieu sec grâce à l'oxyde qui a subi une croissance en milieu humide (80).

11. Matrice de mémoire non volatile (34) comprenant :
un substrat semi-conducteur (70) et un premier oxyde de grille (72) placé sur ledit substrat ;
une pluralité de bandes de polysilicium flottant (30) espacées l'une de l'autre et placées sur ledit premier oxyde de grille ;
une pluralité de bandes de polysilicium de contrôle (28) espacées l'une de l'autre, où chacune desdites bandes de polysilicium de contrôle s'étend perpendiculairement à chacune desdites bandes de polysilicium flottant ;
un diélectrique (76) comprenant du nitrure configuré uniquement dans des zones de croisement situées directement entre lesdites bandes de polysilicium flottant et lesdites bandes de polysilicium de contrôle, moyennant quoi chacun desdits diélectriques est aligné aux bords desdites bandes de polysilicium flottant respectives et desdites bandes de polysilicium de contrôle respectives ; et dans laquelle les bords desdites bandes de polysilicium flottant comprennent de l'oxyde humide (80) qui a subi une croissance sur celles-ci, suivi de l'oxyde sec (82) qui a subi une croissance grâce audit oxyde humide ;
une pluralité d'oxydes de lignes binaires coplanaires (36) formés entre lesdites bandes de polysilicium flottant et lesdites zones de croisement et sous lesdites bandes de polysilicium de contrôle ; et
une pluralité de zones de diffusion formées sous lesdits oxydes de bits linéaires respectifs, où un ensemble composé de ladite pluralité desdites zones de diffusion forme un canal conducteur s'étendant parallèlement à et entre des bandes de polysilicium flottant adjacentes.

12. Matrice de mémoire non volatile selon la revendication 11, dans laquelle ledit diélectrique (76) comprend l'oxyde de polysilicium, un nitrure et un oxyde de nitrure placé dans une structure à trois couches.

13. Matrice de mémoire non volatile selon la revendication 11 ou la revendication 12, dans laquelle ledit oxyde mouillé est formé dans un environnement de vapeur et ledit oxyde sec est formé dans un environnement de O₂.

14. Matrice de mémoire non volatile selon la revendication 11, dans laquelle ledit canal conducteur s'étend à travers la matrice de mémoire vers un point contact adapté pour recevoir une tension au sol.
